(19) Europäisches Patentamt / European Patent Office / Office européen des brevets

(11) **EP 1 951 011 A2**

(12) # EUROPEAN PATENT APPLICATION

(43) Date of publication:
**30.07.2008 Bulletin 2008/31**

(51) Int Cl.:
*H05K 3/24* (2006.01)      *H05K 3/28* (2006.01)

(21) Application number: **08000848.5**

(22) Date of filing: **17.01.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **25.01.2007 JP 2007015586**

(71) Applicant: **Hitachi, Ltd.**
**Chiyoda-ku**
**Tokyo 100-8280 (JP)**

(72) Inventors:
• **Abe, Hiroyuki**
  **c/o Hitachi, Ltd., Intell. Property Group**
  **Tokyo 100-8220 (JP)**
• **Igarashi, Shinya**
  **c/o Hitachi Car Engineering Co., Ltd.**
  **Ibaraki 312-0062 (JP)**

(74) Representative: **Matias, Bruno M.**
**Beetz & Partner**
**Patentanwälte**
**Steinsdorfstrasse 10**
**80538 München (DE)**

(54) **Electronic device installed in an engine room**

(57)    According to the present invention an electronic device, which is to be installed in an engine room, comprises a circuit board 11, electronic elements, which are carried by the circuit board 11 and function when electricity is applied from the circuit board 11 to them, a case 3 that accommodates the circuit board 11 on which the electronic elements are disposed, and a cover 6 that covers an opening of the case 3, the entire surface of a conductor pattern formed of a conductive material on the circuit board is covered with a barrier metallic film made of a metal other than the metal of the conductive material having a property of mutual diffusion with a solder material, and the barrier metallic film is further covered with a protective insulating film.

*FIG. 6*

**EP 1 951 011 A2**

**Description**

BACKGROUND OF THE INVENTION:

(Field of the Invention)

The present invention relates to an electronic device that has a circuit board on which sensors and control unit having a microprocessor operation device, etc. are mounted and particularly, to an electronic device installed in an engine room of a vehicle.

(Description of Related Art)

Electronic devices installed in an engine room of a vehicle are broadly classified into a fuel control unit, which comprises sensors and a control unit, and an ignition control unit, which comprises an igniter and a coil. Some sensors in the fuel control unit sense a flow rate of inhaled air, a flow rate in exhaust gas recirculation (EGR), an air temperature, an atmospheric pressure, a boost pressure, a throttle angle, a stroke position, and other physical quantities. The control unit receives signals from these sensors and controls the combustion state in the cylinder. The ignition control unit controls the timing of ignition by the igniter and coil in the cylinder.

These electronic devices each comprise a board on which electronic driving circuits or electronic control circuits are formed, a base for fixing the board by bonding, a case for accommodating the electronic driving circuits and board, and a cover for covering the case. Soldering is performed to attach capacitors and other parts to conductor wires on the board.

In proposed soldering technology by which capacitors and other parts are mounted on a circuit board, when Sn-Pb solder bumps are formed on a buffer layer or pad for wires, electrodes, and the like formed on the board, particularly, on a buffer layer or pad made of copper or a copper alloy, a barrier layer is formed that provides superior wettability with the Sn-Pb solder bumps. The barrier layer suppresses diffusion of Sn, which is a component of the Sn-Pb solder, and effectively prevents reaction with the buffer layer (Patent Document 1).

Patent Document 1: Japanese Patent Laid-open No. 2003-303787

SUMMARY OF THE INVENTION:

The electronic device installed in an engine room in the present invention comprises a circuit board, electronic elements, which are carried by the circuit board and function when electricity is applied from the circuit board to them, a case that accommodates the circuit board on which the electronic elements are disposed, and/or a cover that covers an opening of the case; the entire surface of a conductor pattern formed of a conductive material on the circuit board is covered with a metallic film made of a metal other than the metal of the conductive material having a property of mutual diffusion with a solder material.

BRIEF DESCRIPTION OF THE DRAWINGS:

FIG. 1A is an enlarged cross sectional view of a main part in an embodiment of an electronic device in the present invention. FIG. 1B is a cross sectional view as taken along line B-B in FIG. 1A.
FIG. 2 is a drawing that schematically illustrates the principle by which the life of a soldered joint is prolonged.
FIG. 3 is a cross sectional view illustrating a state of a protective film covering a conductor wire.
FIG. 4A is an enlarged cross sectional view of a main part in another embodiment of an electronic device in the present invention. FIG. 4B is a cross sectional view as taken along line B-B in FIG. 4A.
FIG. 5 is a cross sectional view in which an air flowmeter 15 is disposed in an intake tube.
FIG. 6 is a cross sectional view illustrating a structure of an on-board electronic device.
FIG. 7 is a cross sectional view of a soldered joint of a chip part in FIG. 6.
FIG. 8 is a drawing illustrating an initial state of diffusion between solder and a conductor wire to be soldered.
FIG. 9 is a drawing illustrating a state in which diffusion of tin in the solder has proceeded at the soldered joint.
FIG. 10 is a drawing illustrating an environment of a corrosive gas and the like in the intake tube in which a thermal-type flowmeter is disposed.
FIG. 11 is a cross sectional view illustrating a state of a protective film covering the conductor wire.

DETAILED DESCRIPTION OF THE INVENTION:

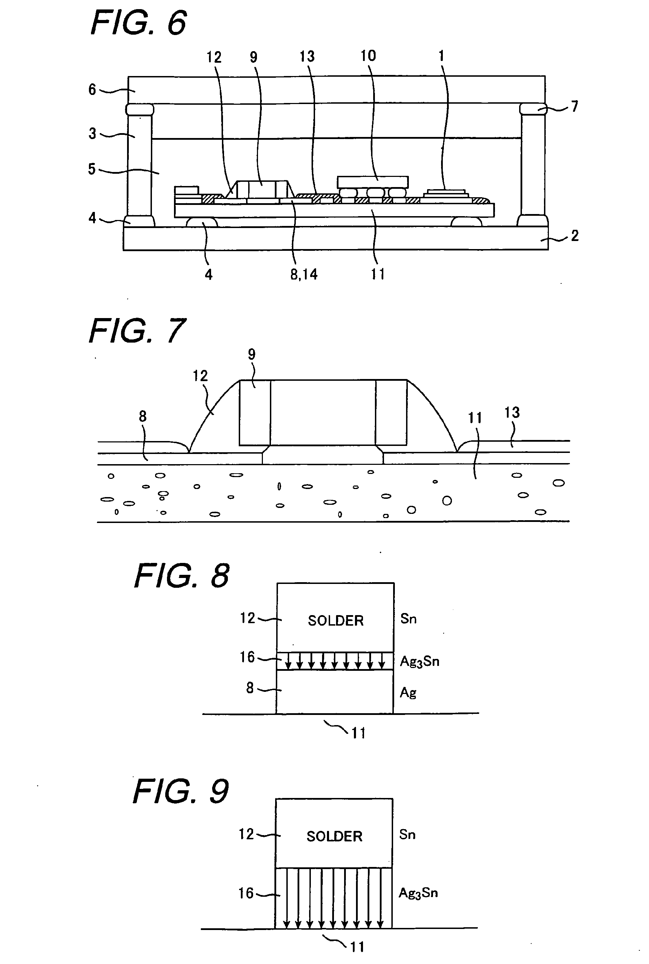

First, the general structure of an electronic device installed in the engine room of a vehicle will be described with reference to FIGs. 6 and 7.

The board 11, on which various types of electronic driving circuits 1 (or electronic control circuits) are mounted, is made of ceramic, glass ceramic (low temperature co-fired ceramic, LTCC), or another inorganic material, or of glass epoxy resin. Conductor wires 8 and resistors are printed on the surface of the board 11 and baked. Of the conductor wire 8, parts that are not soldered are glass-coated to form protective films 13, after which chip parts 9 such as capacitors are soldered to the surface by using solder 12. Diodes and a semiconductor integrated circuit 10 are then mounted, forming a hybrid IC board. On-board electronic devices use this type of hybrid IC board. The hybrid IC board is fixed to a base 2, which is metallic, by bonding with an adhesive 4. The metallic base 2 has a role of a heat sink for dissipating heat, so it is made of a metal having a high thermal conductivity; particularly aluminum is often used.

A case 3 is bonded to the metallic case 2, to which the hybrid IC board has been fixed by bonding with the adhesive 4. A sealant 5 such as silicone gel is then injected and cured.

The case 3 is made of resin so that it has a structure in which a terminal for electrically connecting a sensing element disposed outside the case 3 to the electronic driving circuits 1, etc. inside the case 3 is insert-molded. Since the base 2 is metallic and the case 3 is made of resin, there is a large difference in linear expansion coefficient between the base 2 and the case 3, so the adhesive 4, which is based on silicone and has viscoelasticity, is used to bond them provide sealing between them.

A cover 6 made of resin is fixed to the top surface of the case 3 by bonding with an adhesive 7. When the case 3 and cover 6 are made of different materials, a silicone adhesive is used to bond the cover 6 to the case 3. As the resin to form the case 3 and cover 6, polybutylene terephthalate (PBT), polyphenylene sulfide (PPS), nylon 6, nylon 66, nylon 11, nylon 12, and other resin having a superior property in injection molding are employed in many on-board electronic devices.

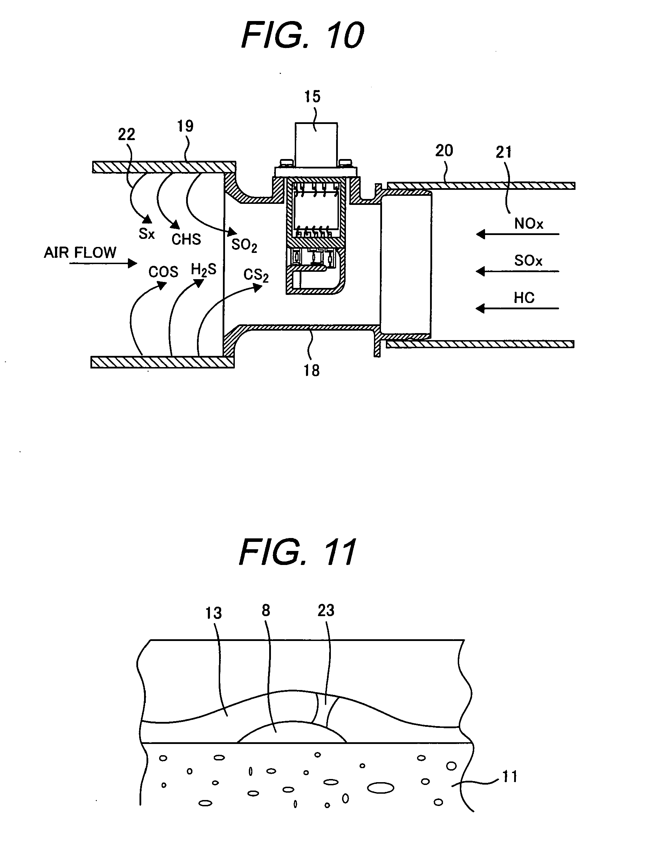

When an air flowmeter is taken as an example of the on-board electronic device, an air flowmeter 15 is fixed to a body 30, and the front end of the body 30 is fixed to an air cleaner 19, the rear end is fixed to an intermediate rubber duct 20, and the air flowmeter 15 is attached to an intake tube for drawing air into the engine, as shown in FIG. 10.

High reliability is increasingly demanded for recent vehicles. For example, although the service life demanded for conventional electronic elements and the like is on the order of 10 years and 100 thousand miles, assurance of 15 or 20 years and 200 thousand miles may be demanded recently.

As described above, however, soldering is carried out for on-board electronic devices to fix the chip parts 9 such as capacitors to the board 11. To prolong the service life of the electronic device, therefore, it is necessary to prolong the life of the soldered joints on the hybrid IC board. The life of the soldered joints will be described with reference to FIGs. 8 and 9.

The conductor wire 8 is made of a metal material that causes mutual diffusion with the solder 12. The surface of the conductor wire, to be soldered, of the chip part 9 is plated with tin, sliver, silver-palladium, solder, or the like, so that the chip part 9 causes mutual diffusion with the solder 12. Accordingly, the chip part 9 is connected to the conductor wire 8 by raising the temperature of the solder 12 above its melting point to melt it.

FIG. 8 illustrates an initial state in which the chip part 9 is diffusion-bonded by the solder 12 to the conductor wire 8, that is, the drawing schematically shows a state immediately after the solder 12 is melted and then hardened. Immediately after the solder 12 is heated and hardened on the conductor material (sliver) of the conductor wire 8 formed on the board 11, mutual diffusion occurs between silver, which is the material of the conductor wire 8, and tin of the solder 12. An intermetallic compound, $Ag_3Sn$ 16, is formed between the layer of the solder 12 and the conductor wire 8 made of silver. The intermetallic compound, $Ag_3Sn$ 16, is stable, hard, and brittle, and it itself does not have a bonding function for connection to another substance.

The mutual diffusion between the tin in the solder 12 and the silver in the conductor wire 8 continues, and thereby the thickness of the diffusion layer is increased with time. The layer of the $Ag_3Sn$ 16 finally diffuses into the entire conductor wire 8 made of silver, as shown in FIG. 9. Since the layer of the $Ag_3Sn$ 16 is stable as described above and thus does not contribute to connection to an electrode, the layer of the $Ag_3Sn$ 16 is peeled off the interface with the board 11.

In general, a factor involved in the life of an electronic device is time taken for the layer of the $Ag_3Sn$ 16 created at the soldered joint at an early stage to diffuse into the entire the silver conductor. This phenomenon is also true for the interface between a chip part and solder.

The air flowmeter 15 will be considered as an example of the electronic device installed in the engine room. In the intake tube in the engine room, as illustrated in FIG. 10, there is a return of a combustion gas 21 from the engine and there are also returns of an unburned gas, gasoline vapor, and engine oil vapor, causing an atmosphere in the engine room in which hydrocarbon is retained.

The rubber duct 20, a hose, and many other products including sulfur are used in the engine room. Since the interior of the engine room becomes hot, gases including sulfur or sulfur compound gases 22 are generated from the rubber duct 20, hose, and other products, changing the interior of the engine room to a corrosive environment. The engine room may be filled with the return of the combustion gas, the return of the unburned gas, the gasoline vapor, the oil vapor, or the hydrocarbon, described above, or a compound gas resulting from theses gases.

Accordingly, the air flowmeter 15 attached to the intake tube is exposed to the return of the unburned gas, the gasoline vapor, the oil vapor, or the hydrocarbon, or a compound gas resulting from theses gases.

The conductor wire 8 formed on the ceramic board 11 of the air flowmeter 15 is often made of silver or a silver alloy. If the conductor wire 8 is brought into contact with a corrosive gas, particularly, a sulfur gas or sulfur compound gas 22, a silver or silver alloy part of the conductor wire 8 is corroded due to sulfur and thereby the conductor wire 8 of the electronic driving circuit 1 is broken, disabling the electronic driving circuit 1 from being activated. Although the air flowmeter 15 has been described as an example of an electronic device installed in the engine room, on-board electronic devices other than the air flowmeter 15 are also exposed to compound gases including hydrocarbon and the like.

Accordingly, the electronic devices installed in the engine room are disposed in the case 3, and the metallic base 2, case 3, and cover 6 are bonded and sealed with an adhesive. In addition, the conductor wire 8 is glass-coated to form the protective film 13 as shown in FIG. 7 so that the conductor wire 8 is protected from the corrosive gas.

As described above, however, it is necessary to use a silicone adhesive to bond the case 3 to the metallic base 2. The silicone adhesive has a physical property specific to silicone resin, which is high gas permeability. In general, industrial macromolecular materials having many polybonds could be said to be gas-shielding bodies because their gas permeability is low. The gas permeability of polyamide (such as nylon) and saturated polyester resin (such as PBT and PET) is low and is not a level that cause a problem in the eyes of common sense. In silicone resin, however, polymers are formed by siloxane bonding in which Si (silicon) and O (oxygen) are directly chained. Since the intermolecular distance of the siloxane bond (-Si-O-Si-) is long, the silicone resin is flexible and has a small molecule rotation steric hindrance and small inter-molecule force, so the silicone resin has a physical property, which is high gas permeability. Accordingly, in an on-board electric device exposed to an environment including a corrosive gas, the corrosive gas 22 penetrates into the part sealed by bonding with the silicone adhesive 4, which should be a sealed part, enters the interior of the case 3, and penetrates even into the sealant 5 such as silicone gel.

As shown in FIG. 11, the protective film 13 formed by glass coating has glass defects 23 such as pinholes, voids, and glass flaws caused by incorrect soldering. However, it is not possible to completely eliminate these glass defects 23, so the corrosive gas entered from the glass defects 23 comes in contact with the conductor wire 8 and corrodes the conductor wire 8. The corrosion may proceed from the glass defects 23 and the entire conductor may be corroded.

The technology described in Patent Document 1 can solve the problem with the life of a solder joint when tin of solder diffuses in the conductor wire made of silver, but the technology does not consider any environment in which the conductor wire is disposed in an engine room and exposed to a corrosive gas.

The present invention addresses the above situation with the object of prolonging the life of the soldered joints of electronic elements to conductor wires on a board in an electronic device used in an engine room and also prolonging the service life of an electronic device including sensor parts and a control unit by improving the corrosion resistance of the conductor wire to the corrosive gas.

To achieve the above object, the electronic device installed in an engine room in the present invention comprises a circuit board, electronic elements, which are carried by the circuit board and function when electricity is applied from the circuit board to them, a case that accommodates the circuit board on which the electronic elements are disposed, and a cover that covers an opening of the case; the entire surface of a conductor pattern formed of a conductive material on the circuit board is covered with a metallic film made of a metal other than the metal of the conductive material having a property of mutual diffusion with a solder material.

According to the present invention, the entire surface of the conductor pattern made of a conductive material is covered with a metallic film made of a metal other than the metal of the conductive material having a property of mutual diffusion with a solder material, and thereby tin of the solder does not diffuse into the conductor material of the conductor pattern, so the life of the connection soldered to dispose an electronic element is prolonged. In addition, since the corrosive gas retained in the engine room is shielded by the metallic film and thus does not come into contact with the conductive material, the conductive material is not broken by being corroded, prolonging the service life of the electronic device.

In the electronic device installed in an engine room in the present invention, the metallic film is covered with a protective insulating film. Therefore, since short-circuits of electronic elements and the like in the electronic device can be prevented and the protective film shields the corrosive gas, the conductive material is less corroded by the corrosive gas.

In the electronic device installed in an engine room in the present invention, the metallic film is specifically made of aluminum, nickel, tin, zinc, gold, platinum, titanium, palladium, chromium, iron, solder, ruthenium, iridium, rhodium, or an alloy including any of these elements, the thickness of the film being 0.05 $\mu$m to 5 $\mu$m, the protective film

being made of glass or a high molecular compound.

In the electronic device installed in an engine room in the present invention, the conductor pattern is specifically made of gold, platinum, nickel, silver, an alloy including silver, or copper.

The electronic device installed in an engine room in the present invention comprises a circuit board, electronic elements that are carried by the circuit board and function when electricity is applied from the circuit board to them, a case that accommodates the circuit board on which the electronic elements are disposed, and a cover that covers an opening of the case; the surface of a conductor pattern formed of a conductive material on the circuit board is covered with an oxide film or nitride film.

According to the present invention, since the surface of a conductor pattern formed of a conductive material on the circuit board is covered with an oxide film or nitride film and thus the corrosive gas retained in the engine room is shielded by the oxide film or nitride film and does not come into contact with the conductive material, the conductive material is not broken by being corroded, prolonging the service life of the electronic device.

In the electronic device installed in an engine room in the present invention, a part to be soldered on the surface of the conductor pattern is covered with a metallic film made of a metal other than the metal of the conductive material having a property of mutual diffusion with a solder material, and a part not covered with the metallic film on the surface of the conductor pattern is covered with an oxide film or nitride film.

According to the present invention, a part to be soldered on the surface of the conductor pattern is covered with a metallic film made of a metal other than the metal of the conductive material having a property of mutual diffusion with a solder material; since tin of solder used for soldering an electronic element to the conductive material of the conductor pattern does not diffuse into the conductive material, the life of the soldered joint can be prolonged; a conductor pattern surface not covered with the metallic film is covered with an oxide film or nitride film and thus the corrosive gas retained in the engine room is shielded by the oxide film or nitride film and does not come into contact with the conductive material, so the conductive material is not broken by being corroded, prolonging the service life of the electronic device.

In the electronic device installed in an engine room in the present invention, an electronic element is connected to the conductor pattern with a conductive adhesive, and a conductor pattern surface to which the conductive adhesive is not applied is covered with an oxide film or nitride film.

In the electronic device installed in an engine room in the present invention, the oxide film or nitride film is covered a protective insulating film. According to the present invention, since the oxide film or nitride film is further covered with a protective insulating film, short-circuits of electronic elements and the like in the electronic device can be prevented, and the protective film shields the corrosive gas, so the conductive material is less corroded by the corrosive gas.

In the electronic device installed in an engine room in the present invention, the oxide film is specifically silica, calcia, magnesia, or a crystal having an ion bonding crystal structure; the nitride film is a nitride of aluminum, silicon, tungsten, molybdenum, or titanium; the electronic device is a thermal-type flowmeter that measures the flow rate of the gas flowing in the intake tube of an internal-combustion device, and is installed in the intake tube.

In the electronic device installed in an engine room in the present invention, the entire surface of the conductor pattern formed of a conductive material on the surface of the circuit board is covered with a metallic film made of a metal other than the metal of the conductive material having a property of mutual diffusion with a solder material, so diffusion of tin included in solder into the conductor pattern is suppressed, thereby prolonging the life of the soldered joint. Since it is also possible to protect the conductor pattern from the corrosive gas in the engine room by covering the conductor pattern with a metallic film, the service life of the electronic device can be prolonged.

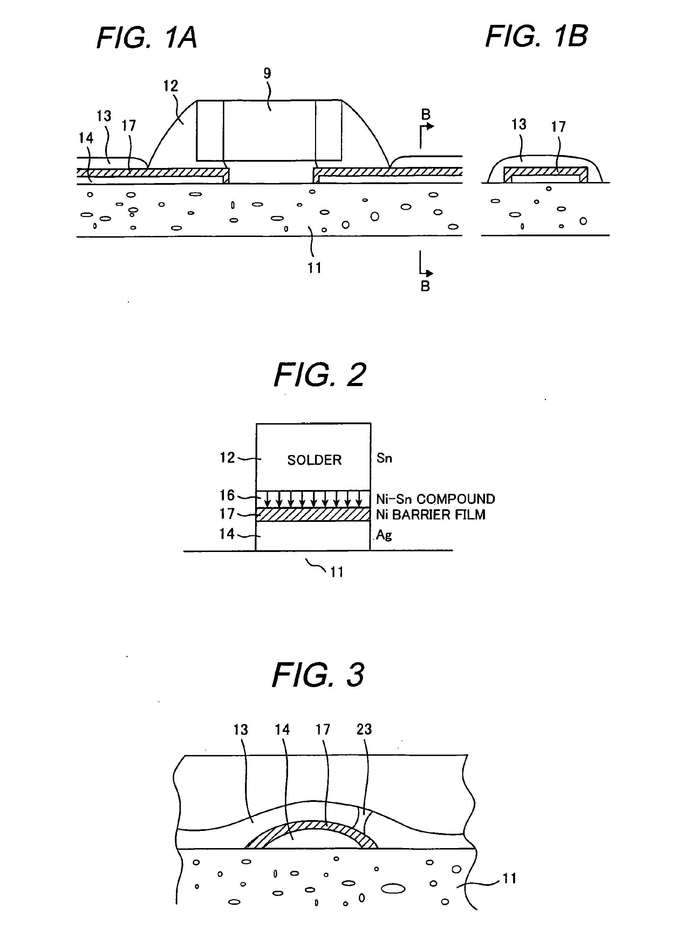

The main part of the electronic device installed in an engine room in the present invention will be described with reference to the drawings. FIGs. 1A and 1B are enlarged views of a main part in an embodiment of the present invention. FIG. 2 schematically illustrates the principle by which the life of a soldered joint in the electronic device is prolonged.

A conductor pattern based on a conductor wire (conductive material) 14 of silver is formed on the surface of the ceramic board 11 by printing, transferring, or plating silver, after which a barrier metallic film 17 is formed on the entire surface of the conductor wire 14 by using nickel, which is a metal other than the metal of the conductor wire 14 having a property of mutual diffusion with a solder material, to cover the periphery of the conductor wire 14. After solder 12 is applied to the barrier metallic film 17, a chip part 9, which is an electronic element, is mounted. When the board 11 passes through a hardening oven (reflow oven), the solder 12 is melted and the chip part 9 is solder-connected to the conductor wire 14 on which the barrier metallic film 17 has been formed. A circuit board on which the chip part 9 is carried by the board 11 is then obtained. In this embodiment, a protective film 13 made of glass or resin is also formed on the top surface of the barrier metallic film 17 so that the circuit board 1 becomes further resistive to corrosive gases.

As shown in FIG. 6, to structure the electronic device in the present invention, the circuit board is fixed to the metallic base 2 by bonding, the case 3 is bonded to the metallic base 2, the sealant 5 such as silicon gel is injected and hardened, and the cover 6 is bonded to the case 3.

In this embodiment, the periphery of the conductor wire 14 made of silver is covered with the barrier metallic film 17 formed of nickel, as schematically shown in FIGs. 1B and 2, so the barrier metallic film 17 suppresses diffusion of tin of the solder 12. It is then suppressed that tin of the solder 12 diffuses into the conductor wire 14 and the Ag$_3$Sn 16 is formed, prolonging the life of a soldered joint.

The barrier metallic film 17 formed of nickel does not corrode even when it comes into contact with gasoline vapor, oil vapor, hydrocarbon, or a corrosive complex gas in which these gases are mixed. According to this embodiment, as shown in FIG. 3, therefore, even if the protective film 13 includes glass defects 23, the conductor wire 14 does not corrode in a short time and thereby the circuit conductor is not broken, because the surface of the conductor wire 14 is covered with the barrier metallic film 17, the barrier metallic film 17 shields the sulfur-based corrosive gas, and thus the corrosive gas does not come into contact with the conductor wire 14 formed of silver. When nickel, titanium, or aluminum is used as the metal of the barrier metallic film 17, the effect of shielding the corrosive gas is significant.

The circuit board 1 formed as described above underwent heat cycle test for 1000 cycles at temperatures of -40 °C to 130 °C. As for the hybrid IC board in the present invention on which the surface of the conductor wire 14 made of silver is covered with the nickel-based barrier metallic film 17, it was confirmed that diffusion of tin was suppressed by the barrier metallic film 17 and there was almost no diffusion of tin into the conductor wire 14 formed of silver, proving that the life of the soldered joint is prolonged.

As for a conventional circuit board on which the surface of the conductor wire 14 is not covered with the barrier metallic film 17, when the chip part 9 was soldered, the solder joint was cut and the state of diffusion of tin on the cross section of the cut portion was analyzed. The extent of the initial mutual diffusion was 3 μm to 4 μm. After the heat cycle was performed for 1000 cycles at temperatures of -40 °C to 130 °C, tin diffused into the conductor wire 14 of silver up to 10 μm. The intermetallic compound, the Ag$_3$Sn 16, was found in many places.

Although, in this embodiment, the conductor wire (conductive material) 14 of silver is formed on the surface of the ceramic board 11, the conductor wire 14 may be formed by printing, transferring, or plating silver-palladium, gold, platinum, or copper on the surface of the board 11. The metal of the barrier metallic film 17 is not limited to nickel; it may be formed by using tin, zinc, gold, platinum, titanium, palladium, chromium, iron, solder, ruthenium, iridium, rhodium, or an alloy including any of these elements. The film thickness is preferably 0.05 μm to 5 μm. If the film thickness is smaller than 0.05 μm, a soldered joint with a desired life may not be obtained. If the film thickness is greater than 5 μm, a soldered joint with a desired life is obtained, but it is wasteful from the economic viewpoint. A preferable combination of the board 11 is such that conductor wire 14, and barrier metallic film 17, the board 11 is an aluminum or ceramic board, the material of the conductor wire 14 formed on the surface of the board 11 is silver, and nickel is used as the metal of the barrier metallic film 17 that covers the entire conductor pattern including the conductor wire 14 formed of the silver.

Mutual diffusion, by which the life of the soldered joint is determined, will be theoretically described. A diffusion coefficient of diffusion of an element into a metal is calculated according to equation (a).

$$D = Ro \times EXP\ (-Q/RT) \dots\dots\dots\dots\dots\dots\dots\dots\ (a)$$

D: Diffusion coefficient
Ro: Coefficient
Q: Activation energy
R: Gas constant
T: Absolute temperature

Activation energy, which is a numerator term in equation (a), is a factor that determines the easiness of the occurrence of diffusion. To have different metals cause mutual diffusion, activation energy needs to be externally given. The smaller the activation energy is, the smaller the external energy is needed to start diffusion. The activation energy is an index of the easiness of starting diffusion.

Coefficient Ro is the frequency of vibration, which is a first-order term of the diffusion coefficient in equation (a). It is an index indicating that as the coefficient becomes larger, diffusion proceeds faster, and vice versa.

Accordingly, mutual diffusion between metals is affected by the correlation between the activation energy and the coefficient Ro. It is known that different values are taken in different combinations of materials.

Table 1 lists the values of the activation energy and coefficients for various elements that cause mutual diffusion (quoted from "Kinzoku deta bukku (Metal data book)", third edition).

[Table 1]

| Activation energy and coefficient | | |
|---|---|---|
| | Activation energy (kJ/mol) | Coefficient Ro (m²/s) |
| Sn ⇔ Ni | 274 | $3 \times 10^{-3}$ |
| Sn ⇔ Ag | 164 | $2.5 \times 10^{-5}$ |
| Sn ⇔ Al | 84.5 | $3.1 \times 10^{-11}$ |
| Sn ⇔ Au | 143 | $4.1 \times 10^{-6}$ |
| Sn ⇔ Cu | 188 | $1.1 \times 10^{-5}$ |
| Sn ⇔ Fe | 232 | $5.4 \times 10^{-4}$ |
| Sn ⇔ Ti | 132 | $3.8 \times 10^{-8}$ |
| Sn ⇔ Zn | 124 | $2.9 \times 10^{-5}$ |

Mutual diffusion between metals will be specifically considered with reference to Table 1. The activation energy between Sn and silver is 164 kJ/mol, and the activation energy between Sn and nickel is 274 kJ/mol; the activation energy between Sn and nickel is greater than the activation energy between Sn and silver. That is, mutual diffusion between Sn and nickel is less likely to occur than mutual diffusion between Sn and silver. So, when soldering is performed for silver, mutual diffusion is more likely to occur than when soldering is performed for nickel. As a result, much more intermetallic compound is created correspondingly, and connection reliability is lost at an early time. Accordingly, if the barrier metallic film 17 of nickel is formed between the conductor wire 14 of silver and solder when an electronic element is soldered to the conductor wire 14 of silver, the diffusion of tin in the solder is delayed (by the effect that intermetallic compound creation is suppressed) and the reliability of connection between the conductor wire 14 and board 11 is improved, as compared when the electronic element is directly soldered to the conductor wire 14 of silver.

As for the engine room of a vehicle, even the maximum temperature in it does not exceed 130°C. In this temperature environment, activation energy exceeding the activation energy point between silver and nickel is not given. When the conductor wire of silver is covered with nickel, therefore, diffusion of tin into silver can be prevented and creation of the $Ag_3Sn$ 16 is suppressed, so the reliability of connection of the chip part 9 in an electronic device can be greatly improved and the improved reliability can be maintained for a long period of time.

Mutual diffusion between Sn and Al will be considered next. The activation energy between Al and Sn is 84.5 kJ/mol, which is lower than the activation energy of other metal combinations, that is, mutual diffusion between Sn and Al starts with the minimum activation energy listed in Table 1. However, the coefficient Ro in mutual diffusion between Sn and Al is $3.1 \times 10^{-11}$. By comparison, the coefficient Ro in mutual diffusion between Sn and silver is $2.5 \times 10^{-5}$. The coefficient Ro in mutual diffusion between Sn and Al is extremely lower than the coefficient Ro in mutual diffusion between Sn and silver, so even when mutual diffusion occurs between Sn and A1, the speed at which the diffusion proceeds is low. This means that since the speed at which the mutual diffusion between Sn and Al proceeds is low, the mutual diffusion is slower than mutual diffusion between Sn and silver. It can be understood that aluminum (A1) can also be used as the metal of the barrier metallic film 17.

It can be known from Table 1 that the barrier metallic film 17 may be made of zinc, gold, titanium, iron, or aluminum described above.

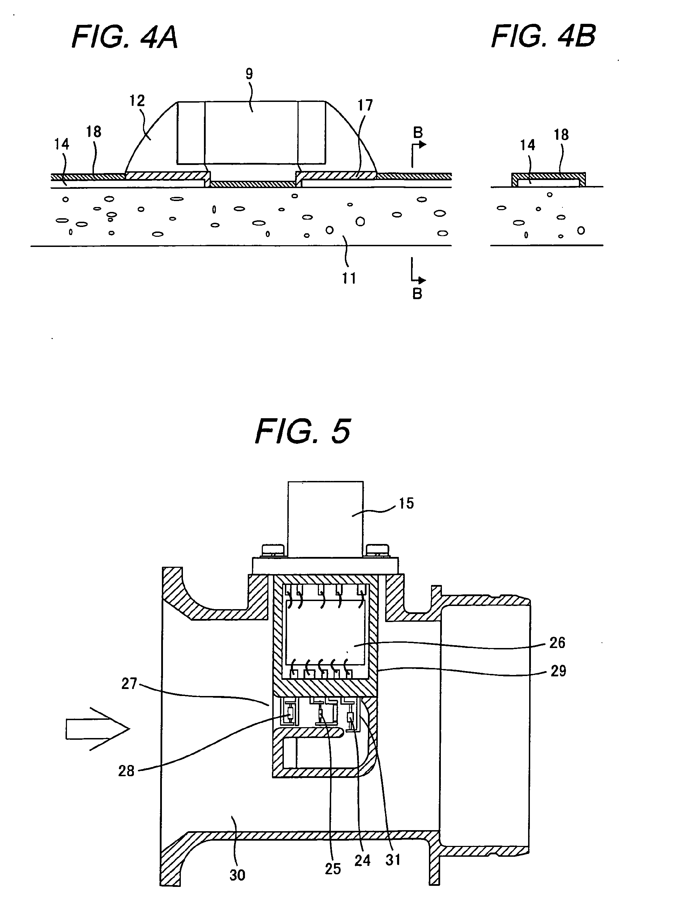

FIGs. 4A and 4B are enlarged views of a main part in another embodiment of the electronic device in the present invention.

In this embodiment, the entire surface of the conductor wire 14 is not covered with the barrier metallic film 17; to cover the conductor wire 14, the barrier metallic film 17 is formed only on a part of the conductor wire 14 to which the chip part 9 is soldered. A barrier film 18 made of silica is formed to cover non-soldered joints of the conductor wire 14.

In this embodiment, the conductor wire 14 does not corrode in a short time and thereby the circuit conductor is not broken, because the surface of the conductor wire 14 is covered with the barrier film 18; the barrier film 18 functions as a barrier film that shields the sulfur-based corrosive gas, and thus the corrosive gas does not come into contact with the conductor wire 14 formed of silver.

The barrier film may be an oxide film or nitride film. An effective oxide film is silica, calcia, magnesia, alumina or a crystal having an ion bonding crystal structure; an effective nitride film is a nitride of aluminum, silicon, tungsten, molybdenum, or titanium.

When the chip part 9 is connected to the conductor wire 14 with a conductive adhesive, the barrier metallic film 17 does not need to be formed on the surface of the conductor wire 14.

If a protective film made of glass or resin is also formed on the top surface of the barrier film 18, the circuit board becomes further resistive to corrosive gases.

There are many types of electronic devices installed in the engine room. The air flowmeter 15 will be described as a concrete example of the electronic device in the present invention.

The air flowmeter 15 is a sensor that is frequently used to measure the flow rate of air drawn into the engine room. Temperature control is performed by a constant-temperature control circuit 26 so that a heat generating resistive element 24 is heated to keep its temperature higher than the temperature of a temperature sensing resistive element 25 by a fixed value. The heat generating resistive element 24 is installed in an air flow. Since its surface is a heat radiating surface, when the air flow rate is high, much heat is radiated from the heat radiating surface. Much more current then flows in the constant-temperature control circuit 26 to heat the heat generating resistive element 24. The air flow rate is obtained by measuring this current.

As the overall structure, in a body 30 that holds the air flowmeter 15 which is a thermal-type flowmeter while supplying intake air, the heat generating resistive element 24, the temperature sensing resistive element 25, and a temperature sensor 28 for measuring the temperature of the intake air are disposed in a sub-channel 27 into which part of the entire air flow flows. These resistive elements and the constant-temperature control circuit 26 transmit electric signals through a terminal 31, which is made of a conductive material and embedded in a case 29. When the structure of the circuit board in the present invention, which has been described with reference to FIGs. 1A and 1B or FIGs. 4A and 4B, is applied to the constant-temperature control circuit 26, the reliability of connection between the circuit part and the conductor formed on the board can be improved and the conductor pattern formed on the circuit board can be effectively protected. Accordingly, a highly reliable air flowmeter 15 can be provided. It should be understood that the application of the present invention is not limited to the air flowmeter 15 described here; the present invention can also be applied to other electronic devices.

The present invention is not limited to the embodiments that have been described. The constituent elements of the present invention are not limited to the structures described above if the characteristic functions of the present invention are not impaired.

The above features and embodiments can be combined in any way partly or as a whole.

**Claims**

1. An electronic device installed in an engine room comprising;
   a circuit board (11),
   an electronic element arranged on the circuit board (11) and supplied with electric current from the circuit board (11), a case (3) that encases the circuit board (11), and
   a cover (6) that covers an opening of the case (3), wherein
   the entire surface of a conductor pattern formed of a conductive material on the circuit board (11) is covered with a metallic film made of a metal other than the metal of the conductive material having a property of mutual diffusion with a solder material.

2. The electronic device installed in an engine room according to claim 1, wherein
   the metallic film is covered with a protective insulating film.

3. The electronic device installed in an engine room according to claim 2, wherein
   the protective film is made of glass or an organic high molecular compound.

4. The electronic device installed in an engine room according to at least one of claims 1 to 3, wherein
   the metallic film is made of a member selected from the group consisting of aluminum, nickel, tin, zinc, gold, platinum, titanium, palladium, chromium, iron, ruthenium, iridium, rhodium, alloys containing at least one of the chemical elements, and solder; and
   the thickness of the metallic film is 0.05-5 $\mu$m.

5. The electronic device installed in an engine room according to at least one of claims 1 to 4, wherein the conductor pattern is made of a member selected from the group consisting of gold, platinum, nickel, silver, alloys containing silver, and copper.

6. An electronic device installed in an engine room comprising;
   a circuit board (11),
   an electronic element arranged on the circuit board (11) and supplied with electric current from the circuit board (11), a case (3) that encases the circuit board (11), and

a cover (6) that covers an opening of the case (3), wherein
the surface of a conductor pattern formed on the circuit board (11) is covered with an oxide film or a nitride film.

7. The electronic device installed in an engine room according to claim 6, wherein
the surface of the conductor pattern to be soldered is covered with a metallic film made of a metal other than the metal of the conductive material having a property of mutual diffusion with a solder material, and a conductor pattern surface not covered with the metallic film is covered with an oxide film or a nitride film.

8. The electronic device installed in an engine room according to claim 6 or 7, wherein
the electronic element is connected to the conductor pattern with a conductive adhesive, and
a conductor pattern surface to which the conductive adhesive is not applied is covered with an oxide film or a nitride film.

9. The electronic device installed in an engine room according to at least one of claims 6 to 8, wherein
the oxide film or the nitride film is covered with a protective insulating film.

10. The electronic device installed in an engine room according to at least one of claims 6 to 9, wherein
the oxide film is a member selected from the group consisting of silica, calcia, magnesia, alumina, and crystals having an ion bonding crystal structure.

11. The electronic device installed in an engine room according to at least one of claims 6 to 10, wherein
the nitride film is a nitride of aluminum, silicon, tungsten, molybdenum, or titanium.

12. The electronic device installed in an engine room according to claim 1, wherein
the electronic device comprises a thermal-type flowmeter (15) that measures a flow rate of a gas flowing in an intake (18) tube of an internal-combustion device, and is installed in the intake tube (18).

*FIG. 1A*          *FIG. 1B*

*FIG. 2*

*FIG. 3*

## FIG. 4A

## FIG. 4B

## FIG. 5

## FIG. 6

## FIG. 7

## FIG. 8

12 — SOLDER — Sn
16 — Ag₃Sn
8 — Ag
11

## FIG. 9

12 — SOLDER — Sn
16 — Ag₃Sn
11

# FIG. 10

# FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003303787 A

**Non-patent literature cited in the description**

- Kinzoku deta bukku (Metal data book